Europäisches Patentamt

**European Patent Office**

Office européen des brevets

(19)

(11) Veröffentlichungsnummer : **0 059 257**
**B1**

(12) **EUROPÄISCHE PATENTSCHRIFT**

(45) Veröffentlichungstag der Patentschrift :
**13.06.84**

(51) Int. Cl.³ : **H 04 B 12/04**

(21) Anmeldenummer : **81109277.4**

(22) Anmeldetag : **29.10.81**

(54) **Verfahren zur Codierung von Analogsignalen.**

(30) Priorität : **27.02.81 DE 3107602**

(43) Veröffentlichungstag der Anmeldung :
**08.09.82 Patentblatt 82/36**

(45) Bekanntmachung des Hinweises auf die Patenterteilung : **13.06.84 Patentblatt 84/24**

(84) Benannte Vertragsstaaten :
**AT BE CH DE FR GB IT LI LU NL SE**

(56) Entgegenhaltungen :
**DE-A- 1 924 484**
**US-A- 3 071 727**
**PROCEEDINGS OF THE IEEE, Band 55, Nr. 10, Oktober 1967, Seiten 1707-1717, New York, USA G.P.
RICHARDS et al.: "Redundancy reduction applied to
coarse-fine encoded video"**

(73) Patentinhaber : **POLYGRAM GmbH**
**Harvestehuder Weg 1-4**
**D-2000 Hamburg 13 (DE)**

(72) Erfinder : **Blüthgen, Björn**
**Gudehusweg 4**
**D-3100 Celle (DE)**

(74) Vertreter : **Mehl, Ernst, Dipl.-Ing.**
**Postfach 22 01 76**
**D-8000 München 22 (DE)**

EP 0 059 257 B1

**Beschreibung**

Die Erfindung bezieht sich auf ein Verfahren zur Codierung von Analogsignalen für Speicher- bzw. Übertragungszwecke, bei dem die abgetasteten Augenblickswerte der Analogsignale in einem Codierer in PCM-Codeworte (PCM-Worte) umgesetzt und anschließend aus jeweils zwei aufeinander folgenden PCM-Worten durch Differenzbildung PCM-Differenzcodeworte (ΔPCM-Worte) gebildet werden, bei dem ferner jedes der eine Impulsgruppe darstellenden ΔPCM-Worte zusammen mit wenigstens einem weiteren Hilfscodeelement ein Codewort mit fest vorgegebener Länge (Referenzcodewort) bilden.

Ein solches Verfahren ist in der älteren europäischen Patentschrift 0 027 233 (Veröffentlichungsdatum 22.4.81) beschrieben.

Wie die Betrachtung der Qualitätsparameter für die Speicherung oder Übertragung codierter Analogsignale zeigt, ergeben sich bei der gleichförmig quantisierten Pulscodemodulation, bezogen auf das Nutzsignal, besonders ungünstige Verhältnisse. Zur Reduzierung der Elementezahl der Codeworte kann von der sogenannten Differenz-Pulscodemodulation Gebrauch gemacht werden, bei der lediglich die Amplitudenänderungen aufeinander folgender Augenblickswerte des Analogsignals in digital codierter Form gespeichert bzw. übertragen werden. Bei gegebenen Qualitätsanforderungen ist dabei die pro ΔPCM-Wort anfallende Codeelementemenge durch die maximal mögliche Änderung der Amplitude zwischen zwei aufeinander folgenden Augenblickswerten des Analogsignals gegeben. Grundsätzlich besteht zwar die Möglichkeit, die Übertragungs- bzw. Speicherkapazität dadurch herabzusetzen, daß die Codeelementemenge eines Codewortes nur so groß gewählt wird, wie sie jeweils für die Darstellung der Größe des Momentanwertes erforderlich ist. Dies erfordert jedoch in jedem Codewort zusätzliche Codeelemente. Bei unterschiedlicher Wortlänge können diese durch Bitfehler verloren gehen, was bei der Rückgewinnung des ursprünglichen Analogsignals Störungen verursacht. Üblicherweise verwenden PCM-Redundanzreduktionsverfahren deshalb für die Übertragung der Augenblickssignalwerte jeweils eine konstante Codeelementemenge, die gegenüber einem bei gleichförmiger Quantisierung vorhandenen Maximalwert reduziert ist. Dabei werden die binär codierten Momentanwerte, einzeln oder blockweise, durch entsprechende zusätzliche Codeelemente gekennzeichnet, kompandiert übertragen. Die Beeinträchtigung der Qualität des zurückgewonnenen ursprünglichen Analogsignals ist in diesem Falle unerwünschterweise vom Kompandierungsgrad abhängig.

Zur Übertragung bzw. Speicherung digital codierter Analogsignale, die die Qualität einer gleichförmig quantisierten Pulscodemodulation auch bei reduzierter konstanter Codeelementegruppe pro Codewort in bezug auf jeden Augenblickswert voll gewährleistet, ist bei dem eingangs genannten Stand der Technik zur weiteren Reduktion des digitalen Signalflusses vorgesehen, das Referenzcodewort einschließlich der Hilfscodeelemente kürzer zu wählen als die maximal mögliche Länge eines ΔPCM-Wortes und die Länge der erzeugten ΔPCM-Worte unter Berücksichtigung der Hilfscodeelemente fortlaufend mit dem Referenzcodewort zu vergleichen und lediglich bei festgestellter Überlänge eines ΔPCM-Wortes dieses entweder durch Wegfall einer Anzahl der jeweils niedrigstwertigen Codeelemente ausreichend gekürzt (kompandiertes ΔPCM-Wort) oder aber durch ein PCM-Wort angepaßter Länge zu ersetzen.

Weiterhin ist es nach dem genannten Stand der Technik bekannt, daß ein solches PCM-Wort angepaßter Länge entweder durch Fortfall seiner jeweils niedrigstwertigen Codeelemente (kompandiertes PCM-Wort) oder aber durch gruppenweise Aufteilung seiner Codeelemente (LSB-Gruppe/MSB-Gruppe) auf zwei aufeinander folgende Codeworte (PCM-Doppelcodewort) gebildet wird.

Da bei Analogsignalen wie Sprache und Musik, große Amplitudenänderungen nur beschränkt und unregelmäßig verteilt auftreten, wirkt sich die hinsichtlich überlanger ΔPCM-Worte erforderliche Umcodierung in PCM-Worte angepaßter Länge praktisch nicht qualitätsmindernd beim zurückgewonnenen ursprünglichen Analogsignal aus. Wie jedoch weitere Untersuchungen zeigen, treten beim Verfahren nach dem älteren europäischen Patent 0 027 233 bei einer fortlaufenden Übertragung eines solchen reduzierten digitalen Signalflusses dann Nachteile auf, wenn auf der Übertragungsstrecke Störungen, beispielsweise kurzzeitige Signalflußunterbrechungen, auftreten. Da im wesentlichen ja nur Signaldifferenzen in Form von ΔPCM-Worten übertragen werden, bewirkt jede Signalflußunterbrechung eine Fehlerfortpflanzung im nachfolgenden Signalfluß, der nur dann korrigiert werden kann, wenn ein PCM-Doppelwort übertragen wird, das gleichsam einen Signalbezugswert darstellt.

Der Erfindung liegt die Aufgabe zugrunde, das Verfahren nach dem älteren europäischen Patent 0 027 233 unter Wahrung der hohen Qualitätsanforderungen dahingehend weiterzubilden, daß solche bei kurzzeitigen Signalflußunterbrechungen auftretenden Fehlerfortpflanzungen weitestgehend vermieden werden.

Diese Aufgabe wird ausgehend von einem Verfahren nach dem älteren europäischen Patent 0 027 233 gemäß der Erfindung dadurch gelöst, daß im Zuge der Reduktion des digitalen Signalflusses zusätzlich ΔPCM-Worte durch PCM-Worte dann ersetzt werden, wenn der zugehörige Signalinhalt einschließlich der erforderlichen Hilfscodeelemente den durch das Referenzcodewort vorgegebenen Codeelementerahmen nicht überschreiten.

Der Erfindung liegt die Erkenntnis zugrunde, daß durch die zusätzliche Übertragung von linear codierten PCM-Worten anstelle von ΔPCM-Worten immer dann, wenn dies im durch das Referenzcodewort vorgegebenen Codeelementerahmen möglich ist, die Anzahl von im Signalfluß auftretenden Signalbezugswerten wesentlich erhöht wird und damit gleichzeitig eine Fehlerfortpflanzung bei kurzzeitigen Signalflußunterbrechungen über eine größere Anzahl von Codeworten hinweg mit Sicherheit ausgeschlossen wird.

Zur weiteren Verbesserung dieses Effektes ist es ferner außerordentlich vorteilhaft, dann ein ΔPCM-Wort durch ein PCM-Doppelwort zu ersetzen, wenn die beiden PCM-Worte, aus denen das ΔPCM-Wort abzuleiten ist, wenigstens annähernd gleichen Signalinhalt aufweisen, der jedoch einschließlich der erforderlichen Hilfscodeelemente den durch das Referenzcodewort vorgegebenen Codeelementerahmen überschreitet.

Die beim Verfahren nach der Erfindung vorgesehene Übertragung mehrerer verschiedener Codewortarten würde normalerweise für ihre jeweilige Kennzeichnung wenigstens zwei Hilfscodeelemente erfordern, also wiederum der gewünschten Reduktion des digitalen Signalflusses entgegenstehen. In Weiterbildung der Erfindung wird zur Vermeidung dieses unerwünschten Effekts zur Markierung der Artfolge der im reduzierten digitalen Signalflüß auftretenden Codeworte, nämlich ΔPCM-Worte, kompandierte ΔPCM-Worte, PCM-Worte, kompandierte PCM-Worte und PCM-Doppelworte eine Kontrollbit-Sequenz mit einer Ein-Bit-Zuordnung pro Codewort verwendet, die im Zuge der Reduzierung des digitalen Signalflusses unter Anwendung bestimmter logischer Verknüpfungen gleichzeitig mit den längenreduzierten Codeworten erzeugt wird und ihrerseits in Abhängigkeit entstehungsfähiger vorgegebener Sequenzteilmuster die Aufeinanderfolge von Arten von Codeworten sowie die entsprechende Decodierung am Ende der Übertragungskette mitsteuert.

Bei einer bevorzugten Ausführungsweise ist ein im Zuge des reduzierten digitalen Signalflusses auftretendes PCM-Wort in der Kontrollbit-Sequenz durch ein Bit markiert, dem sowohl ein inverses Bit vorausgeht als auch nachfolgt. Dabei markieren diese inversen Bits ein dem PCM-Wort vorausgehendes und nachfolgendes ΔPCM-Wort bzw. kompandiertes ΔPCM-Wort.

Vorteilhaft ist es ferner, bei einem im Zuge des reduzierten digitalen Signalflusses auftretenden PCM-Doppelwort die LSB-Gruppe der MSB-Gruppe voranzustellen, und ein solches PCM-Doppelwort stets auf ein ΔPCM-Wort bzw. kompandiertes ΔPCM-Wort und auf ein PCM-Doppelwort stets entweder ein ΔPCM-Wort bzw. kompandiertes ΔPCM-Wort oder, falls vom Signalverlauf her erforderlich, wenigstens ein kompandiertes PCM-Wort oder ein ΔPCM-Wort bzw. ein kompandiertes ΔPCM-Wort folgen zu lassen. Dabei sind in der Kontrollbit-Sequenz die LSB-Gruppe und MSB-Gruppe des PCM-Doppelwortes und das wenigstens eine kompandierte PCM-Wort jeweils zweckmäßig durch ein gleiches Bit und das ΔPCM-Wort bzw. kompandierte ΔPCM-Wort durch ein hierzu inverses Bit markiert.

Da die Übertragung eines linear codierten PCM-Wortes stets eine kleine Signalamplitude des augenblicklichen Signals anzeigt, ist es sinnvoll, im Zuge des reduzierten digitalen Signalflusses hinter einem PCM-Wort stets wenigstens ein ΔPCM-Wort folgen zu lassen.

Anhand eines in der Zeichnung dargestellten Ausführungsbeispieles soll die Erfindung im folgenden noch näher erläutert werden. In der Zeichnung bedeuten:

Fig. 1 ein das Prinzip des Verfahrens nach der Erfindung darstellendes Blockschaltbild,

Fig. 2 ein Beispiel für eine Kontrollbit-Sequenz mit einer die zugehörigen Wortbitgruppen angebenden Tabelle,

Fig. 3 ein Ausführungsbeispiel eines sendeseitigen Codewandlers nach Fig. 1,

Fig. 4 ein Ausführungsbeispiel eines empfangsseitigen Codewandlers,

Fig. 5 bis 7 mehrere die Arbeitsweise des sende- und empfangsseitigen Codewandlers näher erläuternde Funktionsablaufdiagramme.

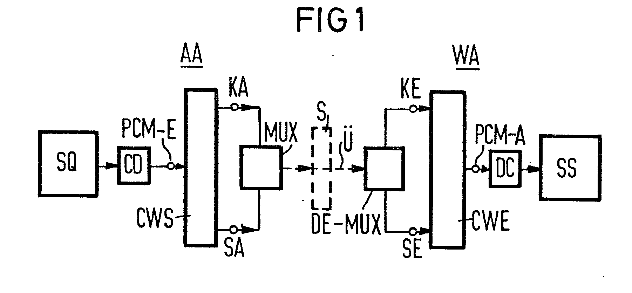

Bei dem in Fig. 1 in Gestalt eines Blockschaltbildes mit einer Aufnahmeanordnung AA und einer Wiedergabeanordnung WA dargestellten Prinzips nach der Erfindung bedeutet SQ eine Signalquelle für analoge Signale, vorzugsweise eine Musik- oder Sprachquelle, die ausgangsseitig mit dem Eingang des Codierers CD verbunden ist. Im Codierer wird das Analogsignal, beispielsweise mit 32 kHz, abgetastet und die Abtastproben in PCM-Worte mit beispielsweise sechzehn Codeelementen pro Wert umgesetzt. Das so gewonnene PCM-Signal wird dem Eingang PCM-E des nachfolgenden sendeseitigen Codewandlers CWS zugeführt, der die gewünschte Reduzierung des digitalen Signalflusses in eine Folge von Codeworten vornimmt, deren Anzahl von Codeelementen, beispielsweise acht Codeelemente entsprechend einer 50 %-Reduktion, wesentlich kürzer ist als die dem sendeseitigen Codewandler CWS eingangsseitig zugeführten PCM-Worte. Die am Ausgang SA anstehenden umgesetzten Codeworte in Form von ΔPCM-Worten, kompandierten ΔPCM-Worten, PCM-Worte, kompandierten PCM-Worten und PCM-Doppelworten werden durch eine gleichzeitig im sendeseitigen Codewandler CWS erzeugte Kontrollbit-Sequenz in der Weise markiert, daß jedem Codewort am Ausgang SA ein Bit der Kontrollbit-Sequenz am Ausgang KA zugeordnet wird. Im dem sendeseitigen Codewandler CWS nachfolgenden Multiplexer MUX werden die Codeworte am Ausgang SA jeweils durch das ihnen zugehörige Bit der Kontrollbit-Sequenz am Ausgang KQ ergänzt und damit auf das Codeelementeformat entsprechend dem vorgegebenen Referenzcodewort gebracht. Anschließend wird der auf diese Weise in der Aufnahmeanordnung AA reduzierte digitale Signalfluß entweder über eine Speicheranordnung S hinweg oder aber über eine Übertragungsstrecke Ü einer Wiedergabeanordnung WA zugeführt. In der Wiedergabeanordnung WA wird gleichsam in umgekehrter Richtung wie bei der Aufnahmeanordnung AA das ursprüngliche analoge Signal aus dem reduzierten digitalen Signalfluß zurückgewonnen. Hierzu werden zunächst im Demultiplexer DE-MUX die Codeworte ihrem Signalinhalt nach von der Kontrollbit-Sequenz getrennt und anschließend diese Codeworte dem Eingang SE und die Kontrollbit-Sequenz dem Eingang KE des empfangsseitigen Codewandlers CWE zugeführt. Vom Ausgang PCM-A des empfangsseitigen Codewandlers CWE werden die zurückgewonnenen PCM-Worte dem Decodierer DC zugeführt, der ausgangsseitig mit der Signalsenke SS verbunden ist.

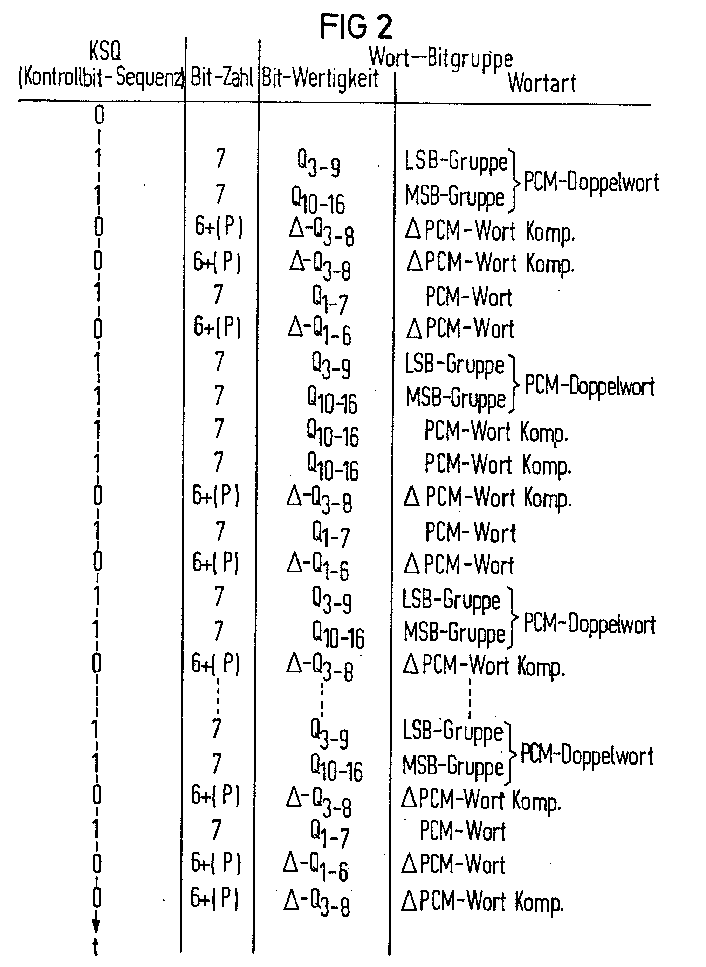

Die in Fig. 2 dargestellte Tabelle zeigt ein Ausführungsbeispiel für eine Aufeinanderfolge von Codeworten in einem 50 % reduzierten digitalen Signalfluß in ihrer jeweiligen Zuordnung zu einem Bit der Kontrollbit-Sequenz, und zwar unter Berücksichtigung einer Codeelementezahl des Referenzcodewortes von acht Codeelementen einschließlich des Bits der Kontrollbit-Sequenz und einer Codeelementezahl der am Ausgang des Codierers CD der Aufnahmeanordnung AA nach Fig. 1 auftretenden Codeworte von sechzehn Codeelementen. Hierbei sind in der ersten Spalte die aufeinander folgenden Bits der Kontrollbit-Sequenz KSQ aufgezeichnet. Eine « 0 » bedeutet eine binäre Null und eine « 1 » eine binäre Eins. Die weiteren drei Spalten geben nähere Auskünfte über die jeweilige im Beispiel gewählte Wortbit-Gruppe, und zwar nach der Bit-Zahl, der Bit-Wertigkeit und der Wortart.

Bei dem in Fig. 2 dargestellten beispielsweisen Ablauf steht am Anfang ein PCM-Doppelwort. Ein solches Doppelwort wird im reduzierten digitalen Signalfluß in zwei aufeinander folgenden Codeworten übertragen, und zwar wird zuerst die Gruppe mit den niedrigstwertigen Bitelementen, die sogenannte LSB-Gruppe, und anschließend die Gruppe mit den höchstwertigen Bitelementen, die sogenannte MSB-Gruppe, erzeugt. In der die Bit-Wertigkeit angebenden Spalte ist die Wertigkeit Q der Bits durch Beigabe arabischer Zahlen dargestellt. Q3-9 bedeutet, daß von dem ursprünglichen PCM-Wort bei Unterdrückung der niedrigstwertigen Bits Q1 und Q2 die nächst höherwertigen Bits Q3 bis Q9 die LSB-Gruppe bilden. Die MSB-Gruppe erfaßt dann die Bits der Wertigkeit Q10 bis Q16. Jede Wort-Bitgruppe umfaßt somit sieben Codeelemente, denen jeweils ein Bit der Kontrollbit-Sequenz KSQ zugeordnet wird, wodurch der durch acht Codeelemente vorgegebene Rahmen des Referenzcodewortes ausgefüllt ist. Die beiden Gruppen eines PCM-Doppelwortes werden in der Kontrollbit-Sequenz KSQ jeweils mit einer « 1.» markiert. Weiterhin ist festgelegt, daß die im reduzierten digitalen Signalfluß auftretenden ΔPCM-Worte bzw. kompandierte ΔPCM-Worte stets durch eine « 0 » markiert sind. Da ein ΔPCM-Wort stets ein

die Polarität anzeigendes Bit « P » erfordert, kann der absolute Differenzwert hier im Hinblick auf den durch das Referenzcodewort vorgegebenen Rahmen nur mit sechs Codeelementen dargestellt werden.

Wie Fig. 2 zeigt, folgt auf das erste PCM-Doppelwort ein kompandiertes ΔPCM-Wort mit der Bitwertigkeit Q3-8. Zur Kennzeichnung des Differenzwertes ist der Bit-Wertigkeit ein Polaritäts-Bit vorangestellt. Das nächste Wort ist ebenfalls ein kompandiertes ΔPCM-Wort. Als fünftes Codewort wird ein PCM-Wort übertragen mit der Bit-Wertigkeit Q1-7. Hierdurch wird angezeigt, daß der Augenblickssignalwert so klein ist, daß er mit den ersten sieben Bit in der Wertigkeitsordnung voll dargestellt werden kann. Das zugehörige Bit der Kontrollbit-Sequenz KSQ ist hier wiederum eine « 1 ». Ein solches PCM-Wort kann jedoch nur dann im Zuge der Codewortfolge erzeugt werden, wenn ihm ein durch eine « 0 » in der Kontrollbit-Sequenz KSQ markiertes ΔPCM-Wort bzw. kompandiertes ΔPCM-Wort vorangestellt ist und nachfolgt. Mit anderen Worten ist hier das PCM-Wort durch die « 1 » in der Kontrollbit-Sequenzfolge 010 markiert.

Da das PCM-Wort einen niedrigen Augenblickssignalwert signalisiert, wird das folgende durch die Kontrollbit-Sequenz erzwungene ΔPCM-Wort nicht kompandiert erzeugt. Als sechstes Wort ergibt sich wiederum ein PCM-Doppelwort, dem zwei kompandierte PCM-Worte folgen. Mit anderen Worten sind kompandierte PCM-Worte in der Kontrollbit-Sequenz KSQ dadurch markiert, daß sie im Anschluß an ein PCM-Doppelwort jeweils mit einer « 1 » erscheinen. Die weiteren in der Folge auftretenden Codeworte in der Tabelle nach der Fig. 2 erklären sich von selbst. Zu erwähnen ist noch, daß die im Anschluß an ein PCM-Doppelwort auftretenden, in der Kontrollbit-Sequenz KSQ mit einer « 0 » markierten kompandierten ΔPCM-Worte als kompandierte ΔPCM-Worte bestimmt werden können, deren Kompandierungsgrad vom jeweiligen relevanten Signalamplituden-Augenblickswertbereich abhängig ist. Dier hier angedeutete Umschaltung bei der Erzeugung von ΔPCM-Worten zwischen mehr oder weniger kompandiert und nicht kompandiert in Abhängigkeit des augenblicklichen Signalverhaltens ermöglicht es, das Verhältnis von PCM- und ΔPCM-Worten nach hörpsychologischen Schwellwertkriterien zu optimieren.·

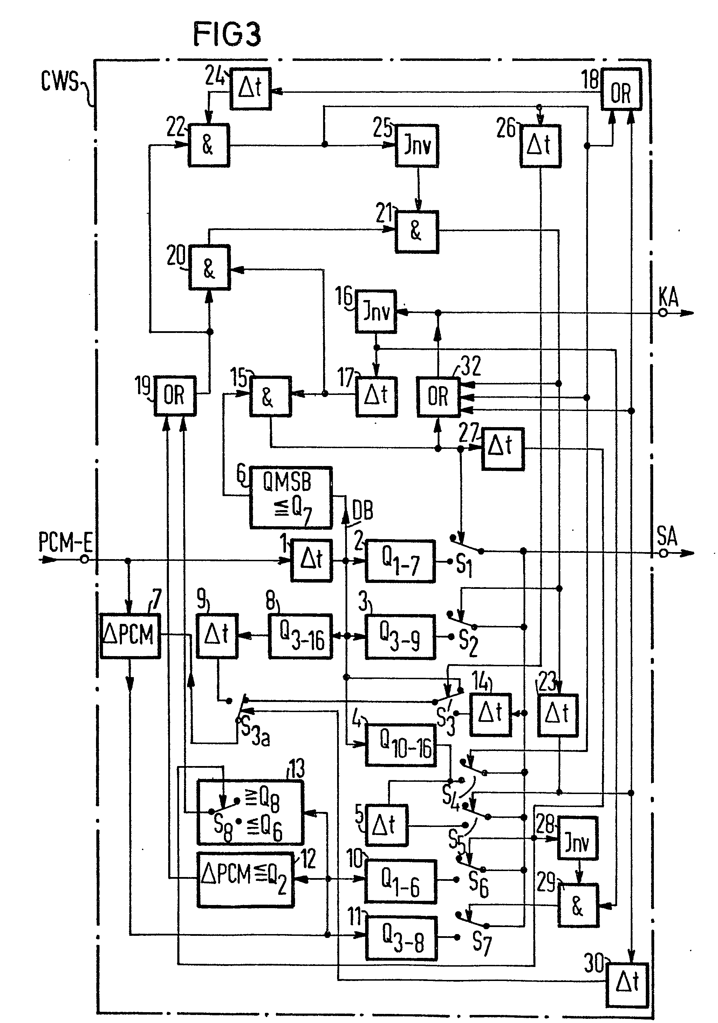

Das in Fig. 3 dargestellte Ausführungsbeispiel eines sendeseitigen Codewandlers CWS weist ein Schaltungskonzept auf, mit dem für einen 50 % reduzierten digitalen Signalfluß eine Wortfolge in Verbindung mit einer Kontrollbit-Sequenz erzeugt wird, wie sie anhand der Tabelle in Fig. 2 erläutert worden ist.

Hierzu weist die Schaltung nach Fig. 3 eine Reihe von Codeelementgruppen-Auswahlstufen 2, 3, 4 und 8 auf, mit denen gezeigt wird, daß von dem Codewort mit jeweils sechzehn Codeelementen Q1-16 führenden Datenbus DB ausgehend, nur für die mit der Codeelementgruppen-Auswahlstufe entsprechend gekennzeichneten Codeelemente eine direkte Signalverbindung zu nachfolgenden Schaltungselementen besteht. Danach erfolgt eine direkte Signalleitung vom Datenbus DB an den Ausgang der Codeelementgruppen-Auswahlstufe 2 nur für die Codeelemente mit der Bit-Wertigkeit Q1-7, an den Ausgang der Codeelementgruppen-Auswahlstufe 3 nur für die Codeelemente mit der Bit-Wertigkeit Q3-9, an den Ausgang der Codeelementgruppen-Auswahlstufe 4 nur für die Codeelemente mit der Bit-Wertigkeit Q10-16 und zum Ausgang der Codeelementgruppen-Auswahlstufe 8 nur für Signale der Datenbus-Codeelementgruppe mit der Bit-Wertigkeit Q3-16.

Die am Eingang PCM-E ankommenden sechzehn Bit aufweisenden PCM-Codeworte werden über die Zeitverzögerungsstufe 1 mit der Zeitverzögerung $\Delta t$, die hier gleich einer PCM-Codewort-Periode gewählt ist, und den Datenbus DB den Codeelementgruppen-Auswahlstufen 2, 3, 4 und 8 zugeführt. Zur Bildung der $\Delta$PCM-Worte werden die eingangsseitig ankommenden PCM-Codeworte gleichzeitig dem einen Eingang der PCM-Codewort-Differenzstufe 7 zugeführt. Die $\Delta$PCM-Worte am Ausgang der PCM-Codewort-Differenzstufe 7 werden in durch die Codeelementgruppen-Auswahlstufen 10 und 11 gekennzeichneter selektiver Signalleitungsführung für die Codeelemente der Bit-Wertigkeit Q1-6 bzw. Q3-8 den Schaltern S6 und S7 sowie unmittelbar den Binärcodewort-Vergleicherstufen 12 und 13 zugeführt. Die Binärcodewort-Vergleicherstufen 12 und 13 entsprechen z. B. in Reihe geschalteten Logik-Bausteinen des RCA-Typs CD 4063 B, mit denen festgestellt werden kann, ob ein binäres Codewort wortmäßig « größer als », « kleiner als » oder « gleichwertig » gegenüber einem Bezugscodewort ist. Ausgangsseitig sind die Codeelementgruppen-Auswahlstufen 2, 3, 4, 10 und 11 mit den Umschaltern S1, S2, S4, S6 und S7 verbunden, die mit ihren Schaltern an den Ausgang SA des sendeseitigen Codewandlers CWS angeschaltet sind. Der weiterhin vorhandene Umschalter S3 verbindet in Ruhestellung den Datenbus DB über den Ruhekontakt des weiteren Schalters S3a mit dem zweiten Eingang der PCM-Codewort-Differenzstufe 7. In Arbeitsstellung des Schalters S3 ist der zweite Eingang der PCM-Codewort-Differenzstufe 7 dagegen über das Zeitverzögerungsglied 14 mit der Verzögerungszeit $\Delta t$ mit dem Ausgang SA verbunden. Der Schalter S3a verbindet seinerseits in Arbeitsstellung den zweiten Eingang der PCM-Codewort-Differenzstufe 7 mit dem Ausgang der Codeelementgruppen-Auswahlstufe 8 über die Zeitverzögerungsstufe 9 mit der Zeitverzögerung $\Delta t$. Der Umschalter S5, der ebenfalls mit seinem Schaltarm an den Ausgang SA angeschaltet ist, verbindet in Arbeitsstellung den Ausgang der Codeelementgruppen-Auswahlstufe über die Zeitverzögerungsstufe 5 mit der Zeitverzögerung $\Delta t$ mit dem Ausgang SA.

Die Binärcodewort-Vergleicherstufe 12 wertet die $\Delta$PCM-Worte vom Ausgang der PCM-Codewort-Differenzstufe 7 darauf hin aus, ob ein $\Delta$PCM-Wort gleich oder kleiner als die Bit-Wertigkeit Q2 ist. Die Binärcodewort-Vergleicherstufe 13 gibt über den internen Schalter S8 in Ruhestellung ein Steuersignal ab, wenn das höchstwertige Bit des jeweiligen $\Delta$PCM-Wortes gleich oder größer als Q8 ist. In Arbeitsstellung gibt die Binärcodewort-Vergleicherstufe 13 über den internen Schalter 8 dann ein Steuersignal ab, wenn das höchstwertige Bit des eingangsseitig anstehenden $\Delta$PCM-Wortes kleiner oder gleich Q6 ist. Eine weitere Binärcodewort-Vergleicherstufe 6 ist an den Datenbus DB angeschaltet, die dann ein Steuersignal abgibt, wenn das höchstwertige eine binäre Eins aufweisende Bit eines über den Eingang PCM-E zugeführten sechzehn Bit PCM-Codewortes kleiner oder gleich der binären Wertigkeit Q7 ist.

Die Binärcodewort-Vergleicherstufen 6, 12 und 13 wirken mit den UND-Gattern & 15, 20, 21, 22 und 29, den ODER-Gattern OR 18, 19 und 32 und den Zeitverzögerungsstufen mit der Zeitverzögerung $\Delta t$ 17, 23, 24, 26, 27 und 30 sowie den Invertern Inv 16, 25 und 28 im Sinne einer logischen Verknüpfung zur Erzeugung der Kontrollbit-Sequenz KSQ zusammen, die dann am Ausgang KA abgegeben wird. Zugleich werden in Verbindung hiermit für die Abgabe der in der Codeelementeanzahl reduzierten Codewortfolge am Ausgang SA die Umschalter S1, S2, S3, S3a, S4, S5, S6, S7 und S8 gesteuert.

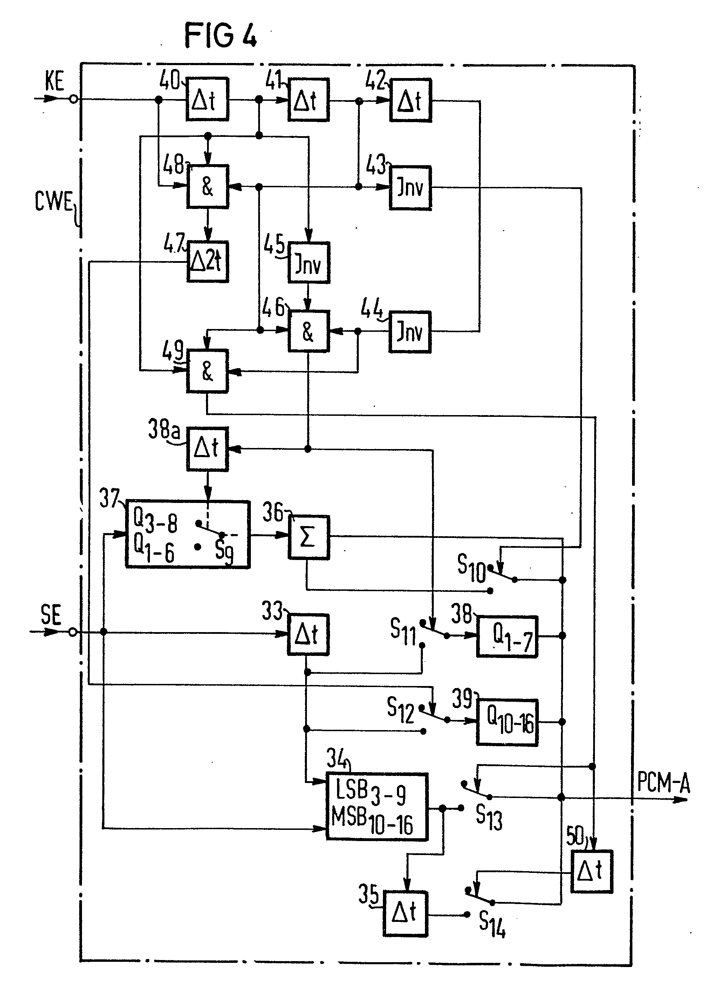

Ein dem sendeseitigen Codewandler CWS entsprechendes Schaltbild für einen empfangsseitigen Codewandler CWE ist in Fig. 4 angegeben. Die am Eingang SE ankommenden Codeworte des reduzierten digitalen Signalflusses werden über die Zeitverzögerungsstufe 33 mit der Zeitverzögerung $\Delta t$ den Schaltern S11 und S12 sowie dem ersten Eingang der PCM-Signalformatierungsstufe 34 zugeführt. Die PCM-Signalformatierungsstufe 34 enthält über den zweiten Eingang gleichzeitig ein jeweils unverzögertes am Eingang SE ankommendes Codewort zugeführt. Ausgangsseitig ist die PCM-Signalformatierungsstufe 34 mit dem Ausgang PCM-A des empfangsseitigen Codewandlers CWE unmittelbar über den Umschalter S13 und mittelbar über die Zeitverzögerungsstufe 35 mit der Zeitverzögerung $\Delta t$ und den Umschalter S14 mit dem Ausgang PCM-A verbunden.

Die auf der Ausgangsseite der Zeitverzögerungsstufe 33 ankommenden Codeworte werden in Arbeitsstellung des Umschalters S11 auf den Eingang der Codewortinhalts-Wertzuordnungsstufe 38 für die Bitgruppe Q1-7 und in Arbeitsstellung des Umschalters S12 mit dem Eingang der Codewortinhalts-Zuordnungsstufe 39 für die Bitgruppe Q10-16 verbunden. Ausgangsseitig sind die Codewortinhalts-Wertzuordnungsstufen 38 und 39 mit dem Ausgang PCM-A verbunden. Weiterhin ist der Ausgang PCM-A mit dem einen Eingang der Summierstufe 36 verbunden, deren Ausgang wiederum in Arbeitsstellung des Umschalters S10 an den Ausgang PCM-A angeschaltet ist. Der zweite Eingang der Summierstufe 36 ist mit dem Eingang SE über den Quantisierungsstufenbewerter 37 verbunden, der in Ruhestellung seines inneren Umschalters S9 die Quantisierungsbewertung in Abhängigkeit davon vornimmt, ob nach einem dem Ausgang PCM-A zugeführten PCM-Codewort entsprechend der zugeordneten Kontrollbit-Sequenz-Kennzeichnung der digitale Signalwert die Wertigkeit des Bitelementes Q7 nicht überschreitet. Die Betätigung des Umschalters S9 erfolgt deshalb zeitverzögert über die Zeitverzögerungsstufe 38 mit der Zeitverzögerung $\Delta$t.

Die Steuerung der Umschalter S9 bis S14 erfolgt ihrer seits in Zusammenarbeit mit einer die Kontrollbit-Sequenz am Eingang KE auswertenden Verknüpfungsschaltung, bestehend aus den UND-Gattern & 46, 48 und 49, den Invertern Inv 43, 44 und 45 und den hinsichtlich der ankommenden Kontrollbit-Sequenz hintereinander geschalteten Zeitverzögerungsstufen 40, 41 und 42 mit der Zeitverzögerung $\Delta$t.

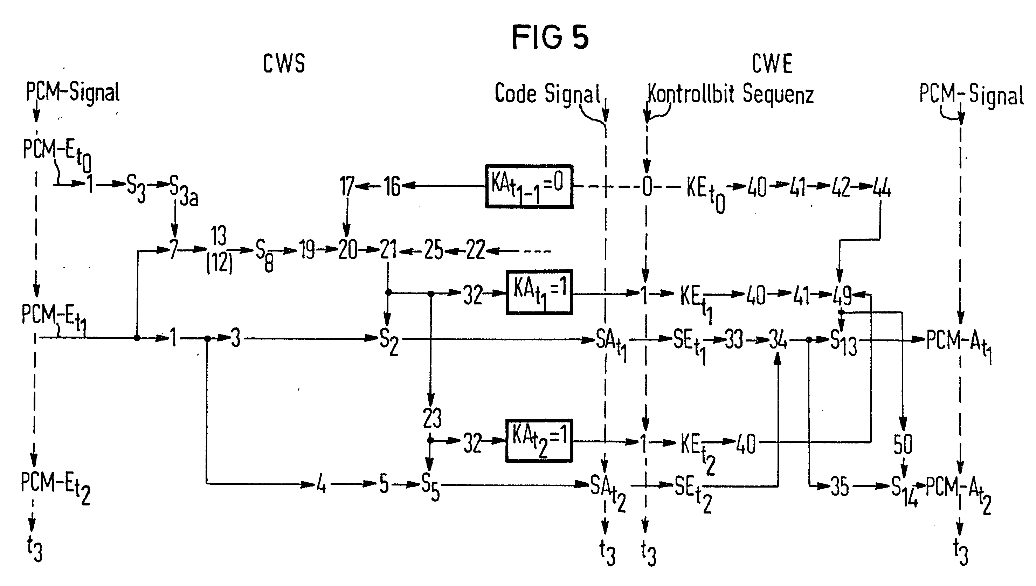

Zur Erläuterung der Arbeitsweise des sendeseitigen Codewandlers CWS und des empfangsseitigen Codewandlers CWE nach den Figuren 3 und 4 sind in den Figuren 5 bis 7 einige Arbeitsfunktionsdiagramme angegeben, die unter anderem auch auf die in Fig. 2 angegebene Tabelle Bezug nehmen. Die Arbeitsfunktionsdiagramme sind so aufgebaut, daß auf der linken Seite die Arbeitsfunktion des sendeseitigen Codewandlers CWS und auf der rechten Seite die Arbeitsfunktion des empfangsseitigen Codewandlers CWE dargestellt ist. Das eingangsseitige PCM-Signal am Eingang PCM-E des sendeseitigen Codewandlers CWS, sowie dessen ausgangsseitiges Code-Signal am Ausgang SA bzw. am Eingang SE des empfangsseitigen Codewandlers CWE, sowie die Kontrollbit-Sequenz am Ausgang KA des sendeseitigen Codewandlers CWS bzw. am Eingang KE des empfangsseitigen Codewandlers CWE, wie auch dessen PCM-Signal am Ausgang PCM-A sind in den Arbeitsfunktionsdiagrammen jeweils durch senkrechte unterbrochene Linien markiert. Außerdem sind die Ein- und Ausgänge zusätzlich mit Zeitschrittangaben ti versehen, die den zeitlichen Ablauf im Rhythmus der aufeinander folgenden Codewortabstände, bezogen auf das PCM-Signal am Eingang PCM-E des sendeseitigen Codewandlers CWS, verdeutlichen.

Das Arbeitsfunktionsdiagramm nach Fig. 5 zeigt zunächst die Erzeugung eines PCM-Doppelwortes entsprecnend dem ersten Wort nach der Tabelle in Fig. 2, wobei davon ausgegangen wird, daß entsprechend den vorgegebenen Mustern der Kontrollbit-Sequenz ein durch eine « 0 » markiertes $\Delta$PCM-Wort erzeugt worden ist. Das umzuwandelnde PCM-Codewort am Eingang PCM-E im Zeitpunkt t1 wird einerseits unmittelbar dem einen Eingang der PCM-Codewort-Differenzstufe 7 und über die Zeitverzögerungsstufe 1, die Codeelementgruppen-Auswahlstufe 3 und den Umschalter S2 dem Ausgang SAt1 zugeführt. Weiterhin wird dieses PCM-Wort hinter der Zeitverzögerungsstufe 1 über die Codeelementgruppen-Auswahlstufe 4, die Zeitverzögerungsstufe 5, den Umschalter S5 dem Ausgang SAt2 zugeführt. Zur Erzeugung des $\Delta$PCM-Wortes am Ausgang der PCM-Codewort-Differenzstufe 7 wird ihrem zweiten Eingang das am Eingang PCM-E im Zeitpunkt t0 anstehende PCM-Codewort über die Zeitverzögerungsstufe 1, den Umschalter S3 und den Umschalter S3a zugeführt.

Die Ansteuerung des Umschalters S2 erfolgt über die PCM-Codewort-Differenzstufe 7 hinweg durch Aktivierung der Binärcodewort-Vergleicherstufen 13 bzw. 12, den Umschalter S8, das ODER-Gatter 19, das UND-Gatter 20 und das UND-Gatter 21. Hierzu erhält einerseits das UND-Gatter 20 an seinem zweiten Eingang über den Inverter 16 und die Zeitverzögerungsstufe 17 durch die « 0 » in der Kontrollbit-Sequenz im Zeitpunkt t1 − 1 den Öffnungsimpuls. In gleicher Weise erhält das UND-Gatter 21 an seinem zweiten Eingang den Öffnungsimpuls über das UND-Gatter 22 und den Inverter 25.

Die die LSB-Gruppe am Ausgang KAt1 und die MSB-Gruppe am Ausgang KAt2 markierende « 1 » der Kontrollbit-Sequenz wird im ersten Fall vom Ausgang des UND-Gatters 21 über das ODER-Gatter 32 und im zweiten Fall über das UND-Gatter 21, die Zeitverzögerungsstufe 23 und das ODER-Gatter 32 erzeugt.

Das am Eingang PCM-E im Zeitpunkt t2 auftretende PCM-Codewort wird unterdrückt, da hierfür im reduzierten digitalen Signalfluß wegen der Erzeugung eines PCM-Doppelwortes kein Platz mehr vorhanden ist. Auf der Ausgangsseite des empfangsseitigen Codewandlers CWE wird dieses unterdrückte PCM-Codewort durch zweimalige Ausgabe des aus dem PCM-Doppelwort zurückgewonnenen Sechzehn Bit PCM-Codeworts am Ausgang PCM-At1 und am Ausgang PCM-At2 kompensiert.

Wie das Arbeitsfunktionsdiagramm auf der Seite des empfangsseitigen Codewandlers CWE zeigt, werden die Bits der Kontrollbit-Sequenz 0-1-1 hintereinander den in Kette geschalteten Zeitverzögerungsstufen 40, 41 und 42 nach Fig. 4 zugeführt. Die LSB-Gruppe am Eingang SEt1 des empfangsseitigen Codewandlers CWE wird über die Zeitverzögerungsstufe 33 dem einen Eingang der PCM-Signalformatierstufe 34 zugeführt. Gleichzeitig steht am anderen Eingang der PCM-Signalformatierstufe 34 die MSB-Gruppe des PCM-Doppelwortes über den Eingang SEt2 an. Aus beiden Gruppen bildet dann die PCM-Signalformatierstufe 34 das ursprüngliche Sechzehn Bit PCM-Codewort, das sie über den Umschalter S13 an den Ausgang PCM-At1 abgibt. Das gleiche Sechzehn Bit PCM-Codewort wird am Ausgang PCM-At2 über die Zeitverzögerungsstufe 35 und den Umschalter S14 abgegeben.

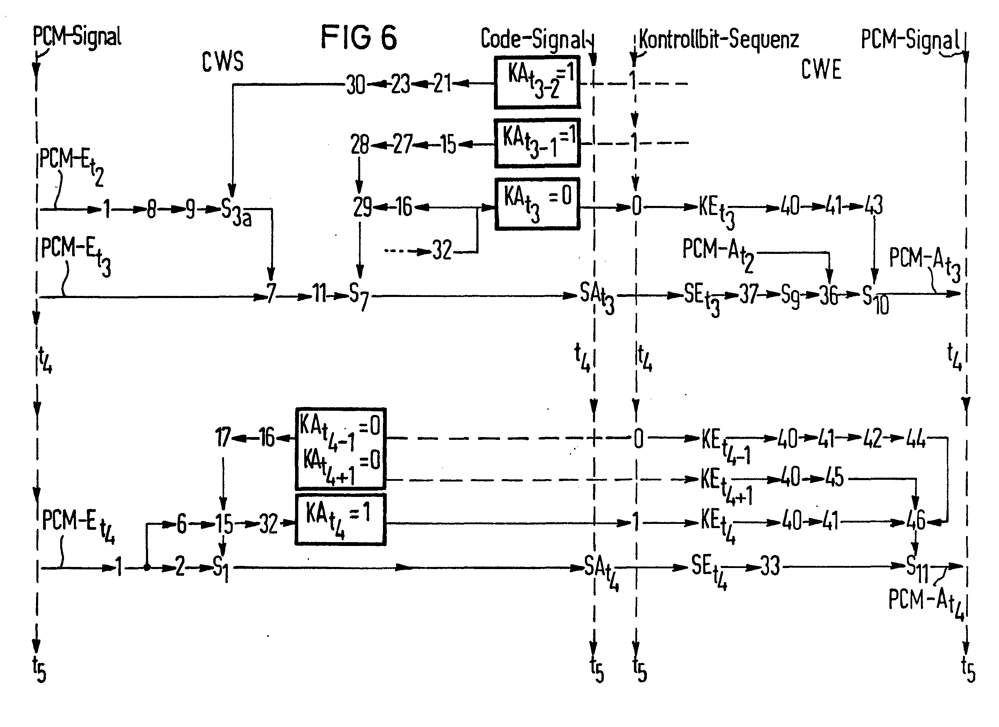

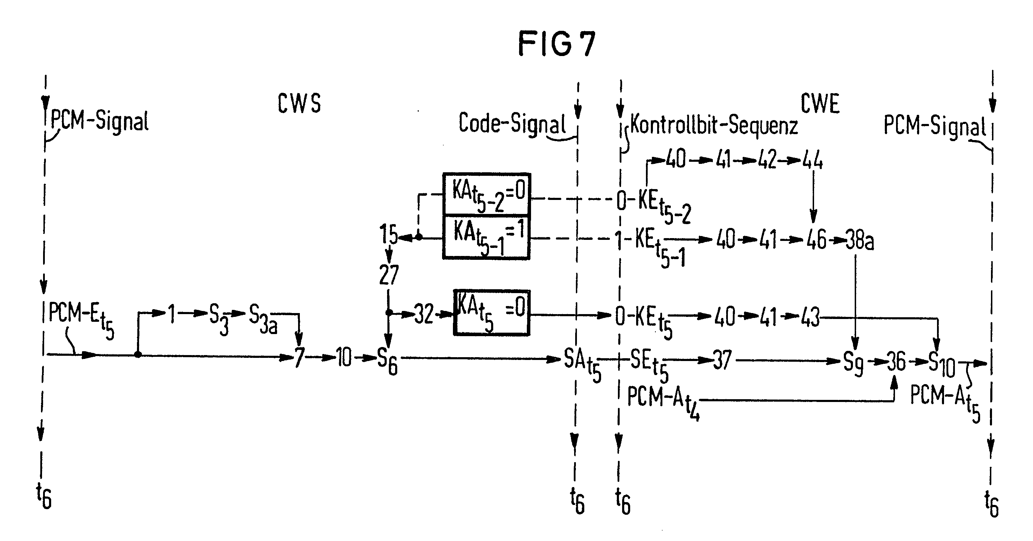

Aus Ubersichtsgründen sind im Arbeitsfunktionsdiagramm nach Fig. 5 wie auch in den anderen Arbeitsfunktionsdiagrammen der Fig. 6 und 7 die Baugruppen des sendeseitigen und des empfangsseitigen Codewandlers wie auch die Umschalter lediglich durch die sie kennzeichnenden Bezugsziffern angegeben.

Das obere Arbeitsfunktionsdiagramm nach Fig. 6 zeigt für den sendeseitigen Codewandler CWS und den empfangsseitigen Codewandler CWE die Erzeugung eines kompandierten ΔPCM-Wortes nach einem PCM-Doppelwort entsprechend der Tabelle nach Fig. 2. Dieses im gewählten Beispiel kompandierte ΔPCM-Wort wird dabei aus der Differenz der PCM-Worte am Eingang PCM-Et2 und PCM-Et3 im sendeseitigen Codewandler CWS gebildet. Im empfangsseitigen Codewandler CWE wird das PCM-Wort am Ausgang PCM-At3 aus der Addition mit dem PCM-Wort am Ausgang PCM-At2 in der Summierstufe 36 zurückgewonnen.

Das untere Arbeitsfunktionsdiagramm der Fig. 6 zeigt die Erzeugung des in der Tabelle nach Fig. 2 vierten Codewortes in Form eines PCM-Wortes sowie seine Rückwandlung im empfangsseitigen Codewandler CWE. Das zugehörige Bit der Kontrollbit-Sequenz ist dabei wiederum eine « 1 », der in der Kontrollbit-Sequenz eine « 0 » sowohl vorangeht als auch nachfolgt.

In gleicher Darstellung zeigt das Arbeitsfunktionsdiagramm nach Fig. 7 die Erzeugung eines nicht kompandierten ΔPCM-Wortes in Anschluß an das PCM-Wort nach der Tabelle in Fig. 2 sowie seine Rückwandlung in das ursprüngliche nicht kompandierte PCM-Wort im empfangsseitigen Codewandler. Das zugehörige Bit der Kontrollbit-Sequenz ist eine « 0 », der in der Kontrollbit-Sequenz direkt eine « 1 » mit zusätzlich vorlaufender « 0 » vorangeht.

**Ansprüche**

1. Verfahren zur Codierung von Analogsignalen für Speicher- bzw. Übertragungszwecke, bei dem die abgetasteten Augenblickswerte der Analogsignale in einem Codierer in PCM-Codeworte (PCM-Worte) umgesetzt und anschließend aus jeweils zwei aufeinander folgenden PCM-Worten durch Differenzbildung PCM-Differenzcodeworte (ΔPCM-Worte) gebildet werden, bei dem ferner jedes der eine Impulsgruppe darstellenden ΔPCM-Worte zusammen mit wenigstens einem weiteren Hilfscodeelement ein Codewort mit fest vorgegebener Länge (Referenzcodewort) bilden, bei dem außerdem zur Reduktion des digitalen Signalflusses das Referenzcodewort einschließlich der Hilfscodeelemente kürzer gewählt ist als die maximal mögliche Länge eines ΔPCM-Wortes und bei dem die Länge der erzeugten ΔPCM-Worte unter Berücksichtigung der Hilfscodeelemente fortlaufend mit dem Referenzcodewort verglichen und lediglich bei festgestellter Überlänge eines ΔPCM-Wortes dieses entweder durch Wegfall einer Anzahl der jeweils niedrigstwertigen Codeelemente ausreichend gekürzt (kompandiertes ΔPCM-Wort) oder aber durch ein PCM-Wort angepaßter Länge ersetzt wird, und zwar entweder durch Fortfall seiner jeweils niedrigstwertigen Codeelemente (kompandiertes PCM-Wort) oder aber durch gruppenweise Aufteilung seiner Codeelemente (LSB-Gruppe/MSB-Gruppe) auf zwei aufeinander folgende Codeworte (PCM-Doppelwort), dadurch gekennzeichnet, daß im Zuge der Reduktion des digitalen Signalflusses zusätzlich ΔPCM-Worte (Δ-Q1-6) durch PCM-Worte (Q1-7) dann ersetzt werden, wenn der zugehörige Signalinhalt einschließlich der erforderlichen Hilfscodeelemente den durch das Referenzcodewort vorgegebenen Codeelementerahmen nicht überschreitet.

2. Verfahren nach Anspruch 1, dadurch gekennzeichnet, daß ein ΔPCM-Wort (Δ-Q1-6) durch ein PCM-Doppelwort (Q3-9 + Q10-16) dann ersetzt wird, wenn die beiden PCM-Worte, aus denen das ΔPCM-Wort abzuleiten ist, wenigstens annähernd gleichen Signalinhalt aufweisen, der jedoch einschließlich der erforderlichen Hilfscodeelemente den durch das Referenzcodewort vorgegebenen Codeelementerahmen überschreitet.

3. Verfahren nach Anspruch 1 und 2, dadurch gekennzeichnet, daß zur Markierung der Artfolge der im reduzierten digitalen Signalfluß auftretenden Codeworte, nämlich PCM-Worte (Δ-Q1-6), kompandierte ΔPCM-Worte (Δ-Q3-8), PCM-Worte (Q1-7), kompandierte PCM-Worte (Q10-16) und PCM-Doppelworte (Q3-9 + Q10-16), ein Kontrollbit-Sequenz (KSQ) mit einer Ein-Bit-Zuordnung pro Codewort verwendet wird, die im Zuge der Reduzierung des digitalen Signalflusses unter Anwendung bestimmter logischer Verknüpfungen gleichzeitig mit den längenreduzierten Codeworten erzeugt wird und ihrerseits in Abhängigkeit entstehungsfähiger vorgegebener Sequenzteilmuster die Aufeinanderfolge von Arten von Codeworten sowie die entsprechende Dekodierung am Ende der Übertragungskette mitsteuert.

4. Verfahren nach Anspruch 3, dadurch gekennzeichnet, daß ein im Zuge des reduzierten digitalen Signalflusses auftretendes PCM-Wort (Q1-7) in der Kontrollbit-Sequenz (KSQ) durch ein Bit (« 1 ») markiert ist, dem sowohl ein inverses Bit (« 0 ») vorausgeht als auch nachfolgt, und daß diese inversen Bits ein dem PCM-Wort vorausgehendes und nachfolgendes ΔPCM-Wort (Δ-Q1-6) bzw. kompandiertes ΔPCM-Wort (Δ-Q3-8) markieren.

5. Verfahren nach Anspruch 3 oder 4, dadurch gekennzeichnet, daß bei einem im Zuge des reduzierten Signalflusses auftretenden PCM-Doppelwort (Q3-9 + Q10-16) die LSB-Gruppe (Q3-9) der MSB-Gruppe (Q10-16) vorangestellt ist, daß ferner ein PCM-Doppelwort stets auf ein ΔPCM-Wort Δ-Q1-6) bzw. kompandiertes ΔPCM-Wort (Δ-Q3-8) und auf ein PCM-Doppelwort stets entweder ein ΔPCM-Wort bzw. kompandiertes ΔPCM-Wort oder, falls vom Signalverlauf her erforderlich, wenigstens ein kompandiertes PCM-Wort (Q10-16) oder ein ΔPCM-Wort (Δ-Q1-6) bzw. ein kompandiertes ΔPCM-Wort (Δ-Q3-9) folgt und daß dabei in der Kontrollbit-Sequenz (KSQ) die LSB-Gruppe und die MSB-Gruppe des PCM-Doppelwortes und das wenigstens eine kompandierte PCM-Wort jeweils durch ein gleiches Bit (« 1 ») und das ΔPCM-Wort bzw. kompandiertes ΔPCM-Wort durch ein hierzu inverses Bit (« 0 ») markiert sind.

6. Verfahren nach einem der vorhergehenden Ansprüche, dadurch gekennzeichnet, daß im Zuge des reduzierten digitalen Signalflusses hinter einem PCM-Wort (Q1-7) stets wenigstens ein ΔPCM-Wort (Δ-Q1-6) folgt.

## Claims

1. Method for coding analogue signals for storage and transmission purposes, wherein the sampled instantaneous values of the analogue signals are converted into PCM code words (PCM words) in a coder, whereupon PCM difference code words (ΔPCM words) are formed from two consecutive PCM words by difference formation, wherein moreover each of the ΔPCM words, which represent a pulse group, together with at least one further auxiliary code element form a code word of pre-determined length (reference code word), wherein moreover in order to reduce the digital signal flow, the reference code word, including the auxiliary code elements, is selected to be shorter than the maximum possible length of a ΔPCM word, and wherein the length of the produced ΔPCM words, taking into account the auxiliary code elements, is continuously compared with the reference code word and only in the event that the excessive length of a ΔPCM word is established is this either adequately shortened by omitting a number of the lowest value code elements (companded ΔPCM word), or else replaced by a PCM word of adapted length, and this in fact either by omitting its lowest value code elements (companded PCM word) or by group-wise distribution of its code elements (LSB group/MSB group) between two consecutive code words (PCM double word), characterised in that during the course of the reduction of the digital signal flow, in addition ΔPCM words (Δ-Q1-6) are replaced by PCM words (Q1-7) whenever the associated signal content, including the requisite auxiliary code elements, does not exceed the code element frame pre-determined by the reference code word.

2. Method as claimed in claim 1, characterised in that a ΔPCM word (Δ-Q1-6) is replaced by a PCM double word (Q3-9 + Q10-16) whenever the two PCM words from which the ΔPCM word is to be derived have a signal content which is at least approximately identical but which, including the requisite auxiliary code elements, exceeds the code element frame pre-determined by the reference code word.

3. Method as claimed in claim 1 and 2, characterised in that in order to mark the type-sequence of the code words which occur in the reduced digital signal flow, namely PCM words (Δ-Q1-6), companded ΔPCM words (Δ-Q3-8), PCM words (Q1-7), companded PCM words (Q10-16) and PCM double words (Q3-9 + Q10-16), a control bit sequence (KSQ) together with a one-bit-allocation per code word is used, which control but allocation is produced during the course of the reduction of the digital signal flow with the use of specific logic links simultaneously with the length-reduced code words, and itself, in dependence upon pre-determined sequence sub-patterns which may occur, co-controls the sequence of types of code words and the corresponding decoding at the end of the transmission chain.

4. Method as claimed in claim 3, characterised in that a PCM word (Q1-7) which occurs in the course of the reduced digital signal flow is marked in the control bit sequence (KSQ) by a bit (« 1 ») which is both preceded and followed by an inverse bit (« 0 »), and that these inverse bits mark a ΔPCM word (Δ-Q1-6) and companded ΔPCM word (Δ-Q3-8) which precede and follow the PCM word respectively.

5. Method as claimed in claim 3 or 4, characterised in that in the event of a PCM double word (Q3-9 + Q10-16) which occurs during the course of the reduced signal flow, the LSB-group (Q3-9) precedes the MBS-group (Q10-16), that moreover a PCM double word always follows a ΔPCM word (Δ-Q1-6) or a companded ΔPCM word (Δ-Q3-8), whereas a PCM double word is always followed either by a ΔPCM word or companded ΔPCM word or, if necessary on the basis of the signal development, at least one companded PCM word (Q10-16) or a ΔPCM word (Δ-Q1-6) or companded ΔPCM-word (Δ-Q3-9), and that in the control bit sequence (KSQ) the LSB-group and MSB-group of the PCM double word and the minimum of one companded PCM word are each marked by an identical but (« 1 ») whereas the ΔPCM word and companded ΔPCM word are marked by an inverse bit (« 0 »).

6. Method as claimed in one of the preceding claims, characterised in that in the course of the reduced digital signal flow a PCM word (Q1-7) is always followed by at least one ΔPCM word (Δ-Q1-6).

## Revendications

1. Procédé pour le codage de signaux analogiques dans des buts de mémorisation et de transmission, suivant lequel les valeurs instantanées échantillonnées des signaux analogiques sont transformées, dans un codeur, en mots de code PCM (mots PCM) et ensuite des mots de code différentiel PCM (mot ΔPCM) sont formés à partir de respectivement deux mots PCM successifs, par formation de la différence, suivant lequel en outre chacun des mots ΔPCM représentant un groupe d'impulsions forme, conjointement avec au moins un autre élément de code auxiliaire, un mot de code possédant une longueur prédéterminée de façon fixe (mot de code de référence), suivant lequel en outre, pour réduire le flux numérique de signaux, le mot de code de référence, y compris les éléments de code auxiliaire, est choisi plus court que la longueur possible au maximum d'un mot ΔPCM, et suivant lequel la longueur des mots ΔPCM produits en tenant compte des éléments de code auxiliaire est comparée en permanence au mot de code de référence et seulement dans le cas d'une surlongueur déterminée d'un mot ΔPCM celui-ci est soit raccourci de façon suffisante par suppression d'un certain nombre des éléments de code présentant respectivement le poids le plus faible (mot ΔPCM comprimé) soit remplacé par un mot PCM de longueur adaptée, et ce, soit par suppression de ses éléments de code présentant respectivement le poids le plus faible (mot PCM comprimé) soit par répartition par groupes de ses éléments de code (groupe LSB/groupe MSB) sur deux mots de code successifs (mot double PCM), caractérisé par le fait qu'au cours de la réduction du flux de signaux numériques des mots ΔPCM (Δ-Q1-6) sont en plus alors remplacés par des mots PCM (Q1-7) lorsque le contenu associé du signal, y compris les éléments de code auxiliaire nécessaires, ne dépasse pas la trame d'éléments de code prédéterminée par le mot de code de référence.

2. Procédé suivant la revendication 1, caractérisé par le fait qu'un mot ΔPCM (Δ-Q1-6) est alors remplacé par un mot double PCM (Q3-9 + Q10-16) lorsque les deux mots PCM, à partir desquels doit être dérivé le mot ΔPCM, possèdent au moins approximativement le même contenu de signal qui cependant, y compris les éléments de code auxiliaire nécessaires, dépasse la trame d'éléments de code prédéterminée par le mot de code de référence.

3. Procédé suivant la revendication 1 et 2, caractérisé par le fait que pour le marquage de la succession des types des mots de code apparaissant dans le flux de signaux numériques réduit, à savoir des mots PCM (Δ-Q1-6), des mots ΔPCM comprimés (Δ-Q3-8), des mots PCM (Q1-7), des mots PCM comprimés (Q10-16) et des doubles mots PCM (Q3-9 + Q10-16), il est utilisé une séquence de bits de contrôle (KSQ) avec une association d'un bit « un » par mot de code, qui est produite au cours de la réduction du flux de signaux numérique en utilisant des combinaisons logiques déterminées, en même temps que les mots de code de longueur réduite, et qui de son côté commande la succession des types de mots de code ainsi que le décodage correspondant à la fin de la chaîne de transmission, en fonction du modèle partiel de séquence prédéterminée susceptible d'apparaître.

4. Procédé suivant la revendication 3, caractérisé par le fait qu'un mot PCM (Q1-7) apparaissant au cours du flux de signaux numérique réduit est marqué dans la séquence de bits de contrôle (KSQ) par un bit (« 1 ») qui est précédé aussi bien que suivi par un bit inversé (« 0 »), et que ces bits inversés marquent un mot ΔPCM (Δ-Q1-6) ou un mot ΔPCM comprimé (Δ-Q3-8) qui précède et qui suit le mot PCM.

5. Procédé suivant la revendication 3 ou 4, caractérisé par le fait que dans le cas d'un mode double PCM (Q3-9 + Q10-16) apparaissant au cours du flux de signaux réduit, le groupe LSB (Q3-9) est placé devant le groupe MSB (Q10-16), qu'en outre un mot double PCM suit toujours un mot ΔPCM (Δ-Q1-6) ou un mot ΔPCM comprimé (Δ-Q3-8), et que soit un mot ΔPCM ou un mot ΔPCM comprimé soit, dans le cas où cela est rendu nécessaire par l'allure des signaux, au moins un mot PCM comprimé (Q10-16) ou un mot ΔPCM (Δ-Q1-6) ou bien un mot ΔPCM comprimé (Δ-Q3-9) suit toujours un mot double PCM, et que, ce faisant, dans la séquence de bits de contrôle (KSQ) le groupe LSB et le groupe MSB du mot double PCM et le mot PCM comprimé au moins prévu sont respectivement marqués par un bit identique (« 1 ») et le mot PCM ou le mot ΔPCM comprimé est marqué par un bit inversé par rapport à celui-ci (« 0 »).

6. Procédé suivant l'une des revendications précédentes, caractérisé par le fait qu'au moins un mot ΔPCM (Δ-Q1-6) suit toujours un mot PCM (Q1-7) au cours du flux de signaux numérique réduit.

# FIG 1

AA | WA

## FIG 2

| KSQ (Kontrollbit-Sequenz) | Bit-Zahl | Bit-Wertigkeit | Wort-Bitgruppe | Wortart |
|---|---|---|---|---|
| 0 | | | | |
| 1 | 7 | $Q_{3-9}$ | LSB-Gruppe ⎫ | PCM-Doppelwort |
| 1 | 7 | $Q_{10-16}$ | MSB-Gruppe ⎬ | |
| 0 | 6+(P) | $\Delta\text{-}Q_{3-8}$ | $\Delta$PCM-Wort Komp. | |
| 0 | 6+(P) | $\Delta\text{-}Q_{3-8}$ | $\Delta$PCM-Wort Komp. | |
| 1 | 7 | $Q_{1-7}$ | PCM-Wort | |
| 0 | 6+(P) | $\Delta\text{-}Q_{1-6}$ | $\Delta$PCM-Wort | |
| 1 | 7 | $Q_{3-9}$ | LSB-Gruppe ⎫ | PCM-Doppelwort |
| 1 | 7 | $Q_{10-16}$ | MSB-Gruppe ⎬ | |
| 1 | 7 | $Q_{10-16}$ | PCM-Wort Komp. | |
| 1 | 7 | $Q_{10-16}$ | PCM-Wort Komp. | |
| 0 | 6+(P) | $\Delta\text{-}Q_{3-8}$ | $\Delta$ PCM-Wort Komp. | |
| 1 | 7 | $Q_{1-7}$ | PCM-Wort | |
| 0 | 6+(P) | $\Delta\text{-}Q_{1-6}$ | $\Delta$PCM-Wort | |
| 1 | 7 | $Q_{3-9}$ | LSB-Gruppe ⎫ | PCM-Doppelwort |
| 1 | 7 | $Q_{10-16}$ | MSB-Gruppe ⎬ | |
| 0 | 6+(P) | $\Delta\text{-}Q_{3-8}$ | $\Delta$PCM-Wort Komp. | |
| ⋮ | ⋮ | ⋮ | ⋮ | |
| 1 | 7 | $Q_{3-9}$ | LSB-Gruppe ⎫ | PCM-Doppelwort |
| 1 | 7 | $Q_{10-16}$ | MSB-Gruppe ⎬ | |
| 0 | 6+(P) | $\Delta\text{-}Q_{3-8}$ | $\Delta$PCM-Wort Komp. | |
| 1 | 7 | $Q_{1-7}$ | PCM-Wort | |
| 0 | 6+(P) | $\Delta\text{-}Q_{1-6}$ | $\Delta$PCM-Wort | |
| 0 | 6+(P) | $\Delta\text{-}Q_{3-8}$ | $\Delta$PCM-Wort Komp. | |
| ↓ t | | | | |

FIG3

0 059 257

# FIG 4

FIG 5

FIG 6

# FIG 7

CWS

CWE

PCM-Signal

Code-Signal

Kontrollbit-Sequenz

PCM-Signal

$40 \rightarrow 41 \rightarrow 42 \rightarrow 44$

$KA_{t_5-2}=0$ — $0-KE_{t_5-2}$

$15$ — $KA_{t_5-1}=1$ — $1-KE_{t_5-1}$ — $40 \rightarrow 41 \rightarrow 46 \rightarrow 38a$

$27$

$PCM-E_{t_5}$ — $1 \rightarrow S_3^- \rightarrow S_{3a}$ — $32 \rightarrow$ $KA_{t_5}=0$ — $0-KE_{t_5}$ — $40 \rightarrow 41 \rightarrow 43$

$7 \rightarrow 10 \rightarrow S_6$ — $SA_{t_5} \mid SE_{t_5} \rightarrow 37$ — $S_9 \rightarrow 36 \rightarrow S_{10}$

$PCM-A_{t_4}$ — $PCM-A_{t_5}$

$t_6$ — $t_6$ — $t_6$ — $t_6$

0 059 257